# EUROPÄISCHE PATENTANMELDUNG

(11) **EP 4 467 490 A1**
(43) Veröffentlichungstag der Anmeldung: **27.11.2024**
(21) Anmeldenummer: 23209757.6
(22) Anmeldetag: 14.11.2023
(51) Int. Cl.: B65G 47/86

(54) **BEHÄLTERTRANSPORTSTERN SOWIE BEHANDLUNGSANLAGE ZUM BEHANDELN VON BEHÄLTERN**

(30) Priorität: 23.05.2023 DE 102023113416
(71) Anmelder: KHS GmbH, 44143 Dortmund (DE)
(72) Erfinder: Schetle, Andreas, 21031 Hamburg (DE); Choinski, Julian, 22359 Hamburg (DE); Schleweis, Daniel, 22395 Hamburg (DE)
(74) Vertreter: Andrejewski - Honke Patent- und Rechtsanwälte Partnerschaft mbB

(57) **Zusammenfassung**

Die Erfindung betrifft einen Behältertransportstern, insbesondere für eine Behandlungsanlage, mit einer Vielzahl von an einem Träger (11) angeordneten Behälteraufnahmen (9), welche durch Rotation des Trägers (11) zwischen einer Eingabe- und einer Ausgabeposition bewegbar sind. Erfindungsgemäß sind zumindest drei in Umfangsrichtung hintereinander angeordnete Behälteraufnahmen (9) zur Bildung einer gemeinsamen Transportgruppe (10) relativ zueinander an dem Träger (9) in Umfangsrichtung verschiebbar ausgebildet.

## Beschreibung

Die vorliegende Erfindung betrifft einen Behältertransportstern mit einer Vielzahl von an einem Träger angeordneten Behälteraufnahmen, welche durch Rotation des Trägers zwischen einer Eingabe- und eine Ausgabeposition bewegbar sind. Insbesondere wird sich auf Behältertransportsterne bezogen, welche in Behandlungsanlagen zum Behandeln von Behältern eingesetzt werden. Hierbei handelt es sich um Anlagen, welche die Behälter oder ein darin angeordnetes Füllgut in einer physikalischen Art und Weise behandeln.

Derartige Behältertransportsterne sind grundsätzlich aus dem Stand der Technik bekannt, wobei sich im Rahmen der Erfindung besonders auf Behältertransportsterne bezogen wird, welche im Rahmen der lebensmittelverarbeitenden Industrie eingesetzt werden. Bei den Behältern handelt es sich vorzugsweise um Getränkeflaschen, welche sowohl aus Glas oder auch aus einem Kunststoff z. B. Polyethylenterephthalat (PET) gebildet sind.

Gerade im Rahmen der Getränkeindustrie ist es üblich, die Behälter zwischen verschiedenen Arten von Behandlungsanlagen zu transportieren. So werden beispielsweise Getränkeflaschen aus Kunststoff üblicherweise zunächst in einer Blasmaschine aus einer sogenannten Preform erzeugt und sodann an eine Behälterfüllanlage übergeben, in welcher ein Füllgut z. B. ein Getränk in die Behälter eingefüllt wird. Darüber hinaus ist es auch bekannt, zwischen der Blasanlage und der Behälterfüllanlage eine sogenannte Behälterbeschichtungsanlage anzuordnen, in welcher die Behälter mit einer innenliegenden Beschichtung versehen werden.

Hierbei ist zu beachten, dass insbesondere Polyethylenterephthalat nur geringe Barriereeigenschaften gegen das Eindringen von Sauerstoff und/oder das Austreten von Kohlendioxid oder anderen Gasen aufweist, sodass mithilfe einer Behälterbeschichtungsanlage eine zusätzliche Barriereschicht innenliegend auf die Behälterwandungen aufgebracht werden kann.

Eine solche Beschichtung erfolgt üblicherweise mithilfe sogenannter Plasmabeschichtungsverfahren, wobei aus einem Plasma heraus die entsprechenden Schichten abgeschieden werden und sich auf den Wandlungen des Behälters absetzen. In diesem Zusammenhang ist auch von sogenannten PICVD-Verfahren ("plasma impuls chemical vapor deposition") die Rede, wobei insbesondere Schichten aus Siliziumoxid abgeschieden werden. Entsprechende Verfahren sind z.B. aus der WO 03/100125 A1 und aus der WO 03/100121 A2 bekannt.

Um einen Transport zwischen den einzelnen Behandlungsanlagen zu ermöglichen, werden entsprechende Behältertransportsterne eingesetzt, in welchen die Behälter zwischen den einzelnen Anlagenteilen transportiert werden. Zugleich werden derartige Behältertransportstern auch dazu verwendet, um die Behälter an die Behälterbehandlungsanlagen zu übergeben oder, um sie aus diesen entnehmen zu können. Sofern sämtliche Behälterbehandlungsanlagen über Behältertransportsterne miteinander verbunden sind, ist auch von einer sogenannten verblockten Bauweise die Rede. Eine solche verblockte Bauweise ergibt sich immer dann, wenn die Behälter gleich getaktet behandelt und transportiert werden, ohne das Pufferstrecken zwischen den einzelnen Behandlungsteilen vorgesehen sind.

Hierdurch wird eine gleichmäßige Produktion mit hoher Taktfrequenz ermöglicht. Zugleich ist aber auch sicherzustellen, dass der Produktionsablauf möglichst zu keinem Zeitpunkt gestört wird, da dann im Wesentlichen die ganze Behandlungsstrecke blockiert wird. Die weitere Besonderheit einer solchen verblockten Bauweise besteht darin, dass die einzelnen Behandlungsanlagen als auch die Transportsterne über weite Strecken eine identische Teilung aufweisen. Eine identische Teilung meint, dass die Behälter sowohl in den Behandlungsanlagen als auch in den Behältertransportsternen mit einem identischen Abstand zueinander transportiert werden. Hierdurch sind allerdings sowohl die Behältertransportsterne als auch den Behandlungsanlagen starken konstruktiven Zwängen unterworfen, sodass entsprechende Umbildungen nicht ohne weiteres möglich sind.

Aus dem Stand der Technik ist es ferner bekannt, dass insbesondere in Behälterbeschichtungsanlagen, eine Vielzahl von Behälterhalterungen zu einer Behandlungsgruppe gruppiert sind, wobei dann die Behälterhalterungen jeweils innerhalb dieser Behandlungsgruppe mit einer zugeordneten Behandlungseinheit ein Behandlungsmodul bilden. Die einzelnen Behandlungsgruppen sind konstruktiv fest miteinander ausgebildet und weisen beispielsweise einen gemeinsamen Plasmaerzeuger sowie einen gemeinsamen Vakuumerzeuger und eine gemeinsame Gaszuführung auf. Bislang sind die einzelnen Behandlungsgruppen so zueinander angeordnet, dass sich nicht nur innerhalb einer Behandlungsgruppe sondern grundsätzlich zwischen allen hintereinander angeordneten Behälterhalterungen dieselbe Teilung einstellt, sodass ausgehend von einem Behältertransportstern die Behälter ohne weiteres den einzelnen Behandlungsgruppen zugeführt werden können.

Je nach Ausgestaltung der Behälterbeschichtungsanlage kann es jedoch erforderlich sein, die Anzahl der Behandlungsmodule zu reduzieren. Um dennoch eine gleichmäßige Teilung zwischen sämtlichen Behälterhalterungen gewährleisten zu können, muss der Durchmesser des Beschichtungsrades reduziert bzw. die einzelnen Beschichtungsmodule auf einem kleineren Außenumfang angeordnet werden.

Da aber eine Vielzahl der für den Betrieb der Beschichtungsanlage erforderlichen Komponenten innerhalb des Behandlungsrades angeordnet ist, ist eine kleinere Auslegung des Durchmessers des Behandlungsrades nicht ohne weiteres möglich.

Aus der EP 3 433 395 B1 ist eine Ausgestaltung bekannt, bei der die Behälter zunächst über einen Luft- oder Bandtransport zugeführt werden und nach einer Vereinzelung zu Gruppen zu je zwei Behältern gruppiert werden. Diese gruppierten Behälter werden dann entsprechend über einen Eingabestern dem Beschichtungsrad zugeführt. Eine solche Ausgestaltung ist jedoch bei einer verblockten Anlage nicht ohne weiteres möglich.

Vor diesem Hintergrund liegt der Erfindung die Aufgabe zugrunde, einen Behältertransportstern anzugeben, welcher eine gruppierte Übergabe von Behältern ermöglicht. Mit einer gruppierten Art und Weise ist in diesem Zusammenhang gemeint, dass die zueinander gruppierten Behälter einen gegenüber der ursprünglichen Teilung verringerten Abstand zueinander aufweisen.

Gegenstand ist ein Behältertransportstern gemäß Patentanspruch 1. Demnach ist erfindungsgemäß vorgesehen, dass zumindest drei in Umfangsrichtung hintereinander angeordnete Behälteraufnahmen zur Bildung einer gemeinsamen Transportgruppe relativ zueinander an dem Träger in Umfangsrichtung verschiebbar ausgebildet sind. Entsprechend ist es möglich, durch Verschiebung der Behälteraufnahmen zueinander an dem Träger die in den Behälteraufnahmen angeordneten Behälter zu gruppieren.

Ausgehend von einer solchen Ausbildung weisen die Behälteraufnahmen dann in der Eingabeposition eine Teilung auf, welche im Zuge der Rotation bis hin zur Ausgabeposition verringert wird. Durch Verringerung der Teilung können die zumindest drei Behälteraufnahmen zueinander gruppiert werden und sodann in dieser gruppierten Art und Weise an eine nachgeschaltete Behandlungsanlage übergeben werden. Ferner ist vorzugsweise vorgesehen, dass durch weitere Rotation die gruppierten Behälteraufnahmen durch Vergrößerung der Teilung wieder degruppiert werden, sodass anschließend neue Behälter in der Eingabeposition hinzugeführt werden können.

Eine bevorzugte Ausgestaltung sieht in diesem Zusammenhang vor, dass zumindest zwei Transportgruppen vorgesehen sind, wobei die Transportgruppen bevorzugt durch eine identische Anzahl von Behälteraufnahmen gebildet sind. Hierbei wird davon ausgegangen, dass die Behälteraufnahmen fest bestimmten Transportgruppen zugeordnet sind. Somit bilden die Behälteraufnahmen auch in einem degruppierten Zustand eine feste Transportgruppe, so dass stets im Zuge der Rotation dieselben Behälteraufnahmen miteinander gruppiert werden. Um eine gleichmäßige Zuführung von Behältern zu ermöglichen sind dann zumindest zwei Transportgruppen vorgesehen, sodass beispielsweise eine erste Transportgruppe im gruppierten Zustand die Behälter an eine nachgeschaltete Behandlungsanlage übergeben kann, während eine zweite Transportgruppe neue Behälter aufnimmt. Selbstverständlich liegt es auch im Rahmen der Erfindung weitere Transportgruppen vorzusehen. Eine besonders bevorzugte Ausgestaltung sieht in diesem Zusammenhang vor, dass zumindest drei Transportgruppen an dem Behältertransportstern gebildet sind.

Eine Weiterbildung der Erfindung sieht ferner vor, dass zumindest zwei der Behälteraufnahmen einer Transportgruppe entlang einer an dem Träger gebildeten Bogenführung verschiebbar sind. Mit einer Bogenführung ist in diesem Zusammenhang eine kurvenförmige Konstruktion gemeint, welche an dem Träger gebildet ist und entlang derer die Behälteraufnahmen verschiebbar geführt sind. Die Bogenführung ist insbesondere kreisbogenförmig ausgebildet und kann integral mit dem Träger ausgebildet sein. Selbstverständlich ist es aber auch möglich, ein separates Bauteil an dem Träger vorzusehen, an welchem die Bogenführung gebildet ist.

Durch die Bogenführung ist es möglich, zumindest zwei der Behälteraufnahmen relativ entlang des Trägers zu verschieben. Die Bogenführung bewirkt hierbei, dass ausschließlich eine Verschiebung in Umfangsrichtung erfolgt, während Verschiebungen insbesondere in radialer Richtung verhindert werden. Selbstverständlich kann es im Rahmen der Erfindung auch vorgesehen sein, dass sämtliche Behälteraufnahmen einer Transportgruppe entlang der Bogenführung verschiebbar sind.

Darüber hinaus kann aber auch eine Behälteraufnahme einer Transportgruppe feststehend an dem Träger angeordnet sein, sodass dann die zumindest zwei weiteren Behälterhalterungen relativ zu der feststehenden Behälterhalterung verschoben werden.

Auch im Hinblick auf die Bogenführung sind unterschiedliche Ausgestaltungen denkbar. Eine erste Möglichkeit besteht darin, die Bogenführung entlang des gesamten Umfangs des Trägers anzuordnen, sodass entsprechend alle verschiebbaren Behälteraufnahmen entlang einer gemeinsamen Bogenführung angeordnet sind. Alternativ ist es aber auch denkbar, mehrere Bogenführungsabschnitte vorzusehen, welche nicht zusammenhängend ausgebildet sind. Hierbei kann dann jedem Bogenführungsabschnitt eine Transportgruppe zugeordnet sein. Sofern also beispielsweise zumindest zwei Transportgruppen vorgesehen sind, bilden sich entsprechend auch drei Bogenführungabschnitte aus. Bei der Ausgestaltung mit drei Transportgruppen sind dann entsprechend drei Bogenführungsabschnitte vorzusehen. Die Bogenführungsabschnitte beschreiben dann vorzugsweise einen Kreisbogenabschnitt, welcher sich entlang eines Kreisbogenwinkels erstreckt.

Eine Weiterbildung der Erfindung sieht ferner vor, dass die Bogenführung eine in dem Träger angeordnete Nut ist und wobei zumindest eine, bevorzugt zwei, verschiebbar ausgebildete Behälterhalterungen einer Transportgruppe mit einem Vorsprung in die Nut eingreifen. Bei der Ausgestaltung mit Bogenführungsabschnitten sind entsprechend dann auch mehrere Nuten vorgesehen, wobei jede Nut einen Bogenführungsabschnitt definiert. Alternativ können auch die verschiebbaren Behälteraufnahmen jeweils eine Nut aufweisen, in welche dann die als Vorsprung ausgebildete Bogenführung eingreift.

Um eine Verschiebung der Behälteraufnahmen zueinander bewirken zu können, sind entsprechende Antriebseinheiten vorzusehen, welche die einzelnen Behälteraufnahmen zueinander verschieben. Grundsätzlich kann hierbei jeder Behälteraufnahme eine Antriebseinheit zugeordnet sein, welche eine entsprechende Verschiebung bewirkt. Da eine solche Ausgestaltung jedoch sehr aufwendig und darüber hinaus fehleranfällig ist, ist es zweckmäßig, eine Koppelung der einzelnen Behälterhalterungen innerhalb einer Transportgruppe vorzusehen, welche eine gleichmäßige Verschiebung und Verstellung zueinander bewirkt.

In diesem Zusammenhang sieht eine besonders bevorzugte Ausgestaltung vor, dass die Behälteraufnahmen zumindest einer Transportgruppe über eine mechanische Kopplungseinrichtung miteinander in Verbindung stehen. Eine mechanische Kopplungseinrichtung weist den Vorteil auf, dass die Anbindung der einzelnen Behälteraufnahmen zueinander festgelegt ist und somit stets sichergestellt wird, dass die Behälteraufnahmen in geeigneter Art und Weise zueinander verschoben werden. Diese Anbindung kann durch verschiedene Arten von Kopplungseinrichtungen bewirkt werden.

Gemäß einer ersten Ausgestaltung ist die mechanische Kopplungseinrichtung als ziehharmonikaartiger Gelenkverbindung ausgebildet, welche die Behälteraufnahmen einer Transportgruppe miteinander verbindet. Diese ziehharmonikaartige Gelenkverbindung ermöglicht es also, dass die Behälteraufnahmen durch Zusammenfalten der Gelenkverbindung aneinander geschoben und durch Auseinanderfalten wieder in die ursprüngliche Teilung zurückgeführt werden. Die Bewegungen der Behälteraufnahmen werden dann durch die Struktur der ziehharmonikaartigen Gelenkverbindung definiert.

Hierbei ist bevorzugt vorgesehen, dass die Gelenkverbindung über eine erste und zweite Gelenkstange jeweils zwei hintereinander angeordnete Behälteraufnahmen miteinander verbindet. Die Gelenkstangen sind hierbei in einem ersten Drehpunkt gelenkig aneinander und in einem zweiten Drehpunkt an den Behälteraufnahmen befestigt. Entsprechend kann durch das Verschwenken der Gelenkstangen zueinander auch eine Bewegung der Behälteraufnahmen zueinander bewirkt werden.

Das Verschwenken der Gelenkstangen erfolgt hierbei insbesondere derart, dass Steuerrollen in den ersten Drehpunkten angeordnet sind. Diese Steuerrollen können radial verschieblich bewegt werden, sodass durch eine radiale Verschiebung nach außen die Gelenkstangen auseinander geschwenkt werden. Dieses Auseinanderschwenken bewirkt ein Auseinanderfahren der Behälteraufnahmen. Im Gegensatz dazu bewirkt eine Verschiebung der Steuerrollen radial nach innen, dass die Gelenkstangen durch Verschwenken aufeinander zubewegt werden. Dies führt gleichermaßen zu einem Verschieben der Behälteraufnahmen bzw. zu einer Gruppierung. Die Anzahl der Steuerrollen richtet sich hierbei vorzugsweise nach Anzahl der ersten Drehpunkte. Sofern also beispielsweise drei Behälteraufnahmen innerhalb einer Transportgruppe vorgesehen sind, so bilden sich durch die ziehharmonikaartige Gelenkverbindung auch zwei erste Drehpunkte innerhalb einer Transportgruppe aus, welche dann entsprechend über die Steuerrollen betätigbar sind. Entsprechend ist es dann durch lediglich zwei Steuerrollen möglich, die Bewegungen von drei Behälteraufnahmen relativ zueinander zu bewirken.

Hierbei kann es vorgesehen sein, dass eine der Behälteraufnahmen einer Transportgruppe feststehend am Träger befestigt oder die Gelenkverbindung ausschließlich radial verschieblich im einem der ersten Drehpunkte ausgebildet ist. Entsprechend wird innerhalb der Transportgruppe ein Fixpunkt geschaffen, welcher die Transportgruppe an dem Träger festlegt. Gemäß der ersten Variante ist eine der Behälteraufnahmen fest an den Träger montiert, sodass sämtliche erste Drehpunkte nicht nur radial verschieblich sondern auch in Umfangsrichtung verschieblich ausgebildet sind. Bei der feststehenden Behälteraufnahme handelt es sich insbesondere um eine mittlere Behälteraufnahme. Dies hat den Vorteil, dass die Wege zum Verschieben vergleichsweise kurz sind.

Alternativ ist es auch möglich, einen ersten Drehpunkt in Umfangsrichtung feststehend auszubilden. Hierbei ist dann eine entlang einer radialen Richtung angeordnete Linearverschiebung vorgesehen, in welcher der erste Drehpunkt bzw. ein in den Drehpunkt angeordnetes Bauteil geführt wird. Entsprechend sind sämtliche Behälterhalterungen einer Transportgruppe in Umfangsrichtung verschiebbar angeordnet, wobei dann ein erster Drehpunkt den Fixpunkt der Transportgruppe an dem Träger bildet. Eine solche Ausgestaltung ist insbesondere dann zweckmäßig, wenn eine gerade Anzahl von Behälterhalterungen innerhalb einer Transportgruppe vorgesehen ist. Dies führt wiederum dazu, dass eine ungerade Anzahl von ersten Drehpunkten vorgesehen ist. So bilden sich beispielsweise bei einer Anzahl von vier Behälteraufnahmen insgesamt drei erste Drehpunkte auf, sodass dann insbesondere vorgesehen ist, dass der mittlere erste Drehpunkt den ausschließlich radial verschieblichen ersten Drehpunkt bildet. Auch hierdurch können wiederum die Wege für die Verschiebung reduziert werden.

Gemäß einer alternativen Ausgestaltung ist die mechanische Kopplungseinrichtung als Zahnradgetriebe ausgebildet. Demnach kann vorzugsweise vorgesehen sein, dass das Zahnradgetriebe aus einem koaxial mit dem Träger verbundenen Stirnrad sowie einer Vielzahl von umlaufend an dem Stirnrad angeordneten Planetenrädern gebildet ist, wobei die Planetenräder jeweils an den Behälteraufnahmen zumindest einer Transportgruppe drehbar in einem zweiten Drehpunkt befestigt sind. Entsprechend weist jede Behälteraufnahme ein zugeordnetes Stirnrad auf, welches in dem zweiten Drehpunkt angeordnet ist. Durch Rotation dieses Stirnrades ist es möglich, die Behälteraufnahmen durch Abrollen auf dem Stirnrad in Umfangsrichtung zu verschieben, sodass die Gruppierung durch geeignete Rotation der Planetenräder bewirkt werden kann.

Dies geschieht bevorzugt dadurch, dass jeweils ein Anlenkhebel in dem zweiten Drehpunkt mit den Planetenrädern verbunden ist. Durch Verschwenken dieses Anlenkhebels wird das jeweilige Planetenrad gegenüber dem Stirnrad in Rotation versetzt, wobei der Schwenkwinkel des Anlenkhebels das Maß bestimmt, mit welchem die Behälteraufnahmen zueinander bzw. auseinander bewegt werden. Das Stirnrad selbst ist fest an dem Träger angeordnet, sodass das Abrollen der Planetenräder an dem Stirnrad lediglich die Verschiebung im Zuge der Gruppierung bewirkt, während der eigentliche Transport der Behälter in den Behälterhalterungen durch die Rotation des Trägers bewirkt wird.

Um ein Verschwenken des Anlenkhebels zu bewirken, ist bevorzugt jeweils eine Steuerrolle an dem Anlenkhebel in einem Abstand zum zweiten Drehpunkt angeordnet. Durch Betätigung dieser Steuerrolle wird der Anlenkhebel betätigt und das Verschieben der Behälteraufnahmen bewirkt. Bei einer solchen Ausgestaltung sind bevorzugt alle Behälteraufnahmen verschiedentlich angeordnet, da mithilfe der Steuerrolle nur ein vergleichsweise kleiner Schwenkwinkel realisiert werden kann, so das dann die Gruppierung durch eine Bewegung aller Behälteraufnahmen zueinander bewirkt wird.

Die Anlenkhebel einer Transportgruppe sind darüber hinaus bevorzugt symmetrisch zueinander angeordnet, sodass insbesondere die außenliegenden Behälteraufnahmen entweder einander zugewandt oder abgewandt sind.

Darüber hinaus kann es gemäß einer bevorzugten Ausgestaltung auch vorgesehen sein, dass die Anlenkhebel zweier hintereinander angeordneter Behälteraufnahmen einer Transportgruppe auf unterschiedlichen Seiten, in umlaufender Bewegungsrichtung der Behälteraufnahmen gesehen, der Planetenräder angeordnet sind. Dies bewirkt, dass die Anlenkhebel zweier hintereinander angeordneter Behälterhalterungen hinsichtlich des Verschwenkens sich nicht gegenseitig blockieren können bzw. ein größerer Schwenkweg zur Verfügung steht.

Unabhängig von der konkreten Ausgestaltung ist darüber hinaus zumindest eine Steuerkurve vorgesehen, mit welcher die Steuerrollen in Eingriff stehen. Bei der Ausgestaltung mit Gelenkverbindung ist es grundsätzlich ausreichend, wenn lediglich eine Steuerkurve vorhanden ist, an der die Steuerrollen abrollen. Grundsätzlich reicht auch bei der Ausgestaltung mit Zahnradgetriebe eine Steuerkurve aus. Allerdings kann es hier auch sinnvoll sein, zumindest zwei Steuerkurven vorzusehen. Dies ist insbesondere dann zwingend notwendig, wenn die Anlenkhebel bzw. die Steuerrollen auf unterschiedlichen Seiten der Planetenräder angeordnet sind.

Eine Weiterbildung der Erfindung sieht ferner vor, dass die Behälteraufnahmen als Behältergreifer, insbesondere als Neckringgreifer, ausgebildet sind. Unter einem Neckring wird ein vorstehender Abschnitt eines Behälters verstanden, welcher unterhalb des Außengewindes angeordnet ist. Dieses Außengewinde dient der Aufnahme einer Verschlusskappe. Eine solche Ausgestaltung ist insbesondere üblich bei Getränkeflaschen. Durch den vorstehenden Neckring eignet sich dieser besonders gut, um die Getränkeflaschen zu halten. Die Greifer können hierbei als passive oder als aktive Greifer ausgebildet sein. Bei einem passiven Greifer werden die Behälter üblicherweise in die Behälteraufnahmen hineingedrückt und dort durch ein Federelement gehalten. Ein aktiver Greifer erfordert hingegen eine aktive Ansteuerung der Greiferzangen, um den Behälter innerhalb der Behälteraufnahme zu halten.

Gegenstand der Erfindung ist ferner eine Behandlungsanlage gemäß Patentanspruch 17 zum Behandeln von Behältern. Insbesondere handelt es sich hierbei um eine Anlage zum Beschichten von Behältern, sodass dann die Behandlungsanlage als Behälterbeschichtungsanlage ausgebildet ist. Die Behandlungsanlage weist ein Behandlungsrad und eine Vielzahl in Umfangsrichtung hintereinander an dem Behandlungsrad angeordneten Behandlungsmodulen auf, welche jeweils eine Behälterhalterung und eine der Behälterhalterung zugeordnete Behandlungseinheit aufweisen, welche dazu eingerichtet sind, die Behälter während einer Rotation des Behandlungsrades zu behandeln und wobei jeweils zumindest drei hintereinander angeordnete Behandlungsmodule zu einer Behandlungsgruppe zusammengefasst sind und wobei die Behandlungsmodule innerhalb einer Behandlungsgruppe in einer ersten Teilung und zwei unmittelbar aneinander angrenzende Behandlungsmodule unterschiedliche Behandlungsgruppen in einer zweiten Teilung zueinander angeordnet sind, wobei die zweite Teilung größer ausgebildet ist als die erste Teilung.

Ausgehend von einer solchen Ausgestaltung ist erfindungsgemäß vorgesehen, dass zumindest ein erfindungsgemäßer Behältertransportstern der zuvor beschriebenen Art und Weise als Einlaufstern dazu eingerichtet ist, die Behälter einer Transportgruppe zwischen der Eingabe- und der Ausgabeposition mit einer ersten Teilung zu gruppieren und an einem Einlauf des Behandlungsrades an eine Behandlungsgruppe zu übergeben. Entsprechend bilden die Transportgruppen innerhalb des Behältertransportsterns die Behandlungsgruppen nach. Diese werden entsprechend in dem Behältertransportstern gruppiert und infolge dessen mit einer zweiten Teilung zueinander angeordnet. Mit dieser zweiten Teilung werden dann die Behälter an das Behandlungsrad übergeben.

Entsprechend sieht eine bevorzugte Weiterbildung der Erfindung vor, dass zumindest ein weiterer erfindungsgemäßer Behältertransportstern als Auslaufstern dazu eingerichtet ist, die Behälter einer Behandlungsgruppe aus dem Behandlungsrad zu entnehmen und innerhalb einer Transportgruppe zwischen der Eingabe- und eine Ausgabeposition ausgehend von der ersten Teilung zu degruppieren. Üblicherweise erfolgt im Zuge der Degruppierung eine Rückführung der Behälter innerhalb einer Transportgruppe von der ersten Teilung in die zweite Teilung. Selbstverständlich ist es aber auch möglich, dass die Behälter vor und nach dem Auslaufstern in einer dritten Teilung transportiert werden, sodass eine Gruppierung ausgehend von der dritten Teilung in die erste Teilung erfolgt. In dem Auslaufstern erfolgt dann eine Degruppierung der Behälter. Der Abstand der Behälter zueinander kann im Zuge dessen von der ersten Teilung in die dritte Teilung überführt werden. Eine solche Ausgestaltung ermöglicht den flexiblen Einsatz von Behandlungsanlagen mit unterschiedlichen Teilungen, ohne dass hierfür die Teilung den übrigen Anlagenkomponenten entsprechen muss.

Wenngleich die Erfindung für verschiedene Arten der Behälterbehandlung einsetzbar ist, so wird sich insbesondere auf Beschichtungsanlagen bezogen. In diesem Fall sind die Behandlungseinheiten als Beschichtungseinheiten ausgebildet. Insbesondere kommen Beschichtungseinheiten zum Einsatz, welche nach Art des PCIVD-Verfahrens arbeiten. Die Beschichtungseinheiten weisen dann unter anderem ein Plasmaerzeuger sowie einen Vakuumerzeuger auf. Zugleich sind die einzelnen Behälteraufnahmen einer Behandlungsgruppe einer gemeinsamen Ventilanordnung zugeordnet, über welche einerseits das Vakuum in den Behältern erzeugt wird und gleichermaßen auch die Gase zugeführt werden, aus denen dann durch Einbringen von Energie durch den Plasmaerzeuger die Barriereschichten abgeschieden werden.

Im Folgenden wird die Erfindung anhand von Ausführungsbeispielen näher erläutert. Es zeigen:
- Fig. 1: eine schematische Darstellung einer Beschichtungsanlage mit erfindungsgemäßen Behältertransportsternen
- Fig. 2: eine Draufsicht auf einen erfindungsgemäßen Behältertransportstern gemäß einer ersten Alternative mit Gelenkverbindungen
- Fig. 3: der Behältertransportstern gemäß der Fig. 2 mit dargestellter Steuerkurve
- Fig. 4: eine weitere Variante der Ausgestaltung gemäß der Fig. 2
- Fig. 5: eine Draufsicht auf eine erfindungsgemäßen Behältertransportstern gemäß einer zweiten Alternative mit Zahnradgetriebe
- Fig. 6: eine isometrische Ansicht der Behälteraufnahmen für einen Behältertransportstern gemäß der Fig. 5.

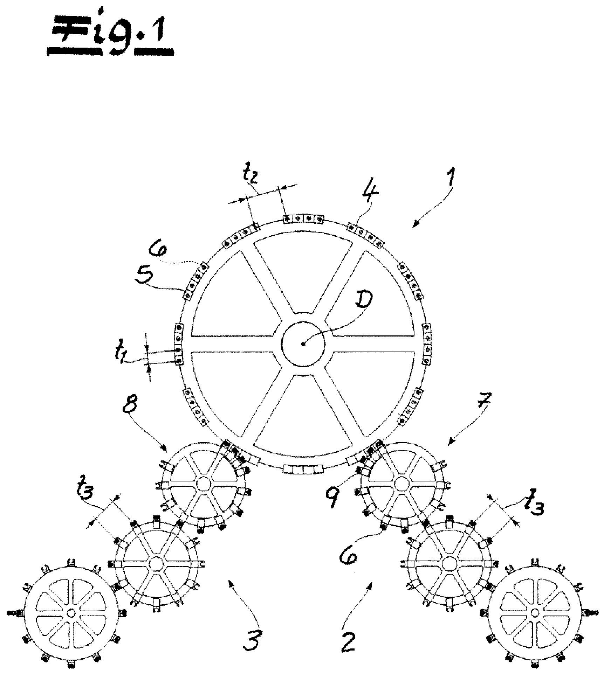

Die Fig. 1 zeigt eine Behandlungsanlage, welche als Beschichtungsanlage zum Beschichten von Behältern 6 ausgebildet ist, wobei es sich bei den Behältern 6 in bevorzugter Weise um Getränkeflaschen aus Kunststoff, insbesondere aus Polyethylenterephthalat, handelt.

Die Behandlungsanlage weist ein Behandlungsrad 1 sowie eine vorgelagerte Einlaufanordnung 2 und eine nachgeschaltete Auslaufanordnung 3 auf. Das Behandlungsrad 1 ist in einer Drehachse D rotierbar antreibbar und weist eine Vielzahl von in Umfangsrichtung angeordneten Behandlungsmodulen 4 auf, welche wiederum jeweils aus einer Behälterhalterung und einer der Behälterhalterung zugeordneten Behandlungseinheit bestehen. Die Behandlungsmodule 4 sind dazu eingerichtet, die Behälter 6 während einer Rotation des Behandlungsrades 1 zu Beschichten, wobei im Rahmen der Erfindung üblicherweise zunächst ein Vakuum in den Behältern 6 erzeugt und sodann innenliegend in den Behältern 6 eine Beschichtung aus einem Plasma abgeschieden wird.

Die Behandlungsmodule 4 sind ferner zu Behandlungsgruppen 5 zu je vier Behandlungsmodulen 4 zusammengefasst, sodass jeweils zeitgleich in den vier Behandlungsmodulen 4 einer Behandlungsgruppe 5 eine Beschichtung der Behälter 6 erfolgt. Die Behandlungsmodule 4 sind hierbei so entlang des Umfangs an dem Behandlungsrad 1 angeordnet, dass die Behandlungsmodule 4 innerhalb einer Behandlungsgruppe 5 in einer ersten Teilung t₁ und zwei unmittelbar aneinander angrenzenden Beschichtungsmodule 4 unterschiedlicher Behandlungsgruppen 5 in einer zweiten Teilung t₂ zueinander angeordnet sind.

Unter einer Teilung ist im Rahmen der Erfindung im Wesentlichen der Abstand der Behandlungsmodule 4 zueinander zu verstehen, welche sich auf den Umfang bezieht, an denen die Behandlungsmodule 4 angeordnet sind.

Anhand der Fig. 1 ist ersichtlich, dass die Teilung t₂, welche sich auf zwei Behandlungsmodule 4 unterschiedlicher Behandlungsgruppen 5 bezieht größer ist als die erste Teilung t₁.

Dies hat wiederum zur Folge, dass die Behälter 6 in einer gruppierten Art und Weise dem Behandlungsrad 1 zugeführt bzw. wieder aus diesem entnommen werden müssen. Entsprechend sind sowohl der als Einlaufstern 7 ausgebildete Behältertransportstern als auch der als Auslaufstern 8 ausgebildete Behältertransportstern, welche jeweils unmittelbar an das Beschichtungsrad 1 angrenzen, dazu eingerichtet, vier Behälter 6 im Zuge einer Umlaufbewegung in der ersten Teilung t₁ zueinander zu gruppieren und an die Behandlungsmodule 4 einer Behandlungsgruppe 5 zu übergeben bzw. im Falle des Auslaufsterns 8 im Zuge einer Umlaufbewegung die vier Behälter 6 in der ersten Teilung t₁ gruppiert aus den Behandlungsmodulen 4 einer Behandlungsgruppe 5 zu entnehmen.

Anhand der Fig. 1 ist ferner ersichtlich, dass die Behälter 6 dem Einlaufstern 7 in einer dritten Teilung t₃ zugeführt werden und diese dann im Zuge einer Rotation des Einlaufrades 7 reduziert wird, sodass vor Übergabe an das Behandlungsrad 1 die Behälter 6 in dem Einlaufrad 7 eine erste Teilung t₁ zueinander aufweisen.

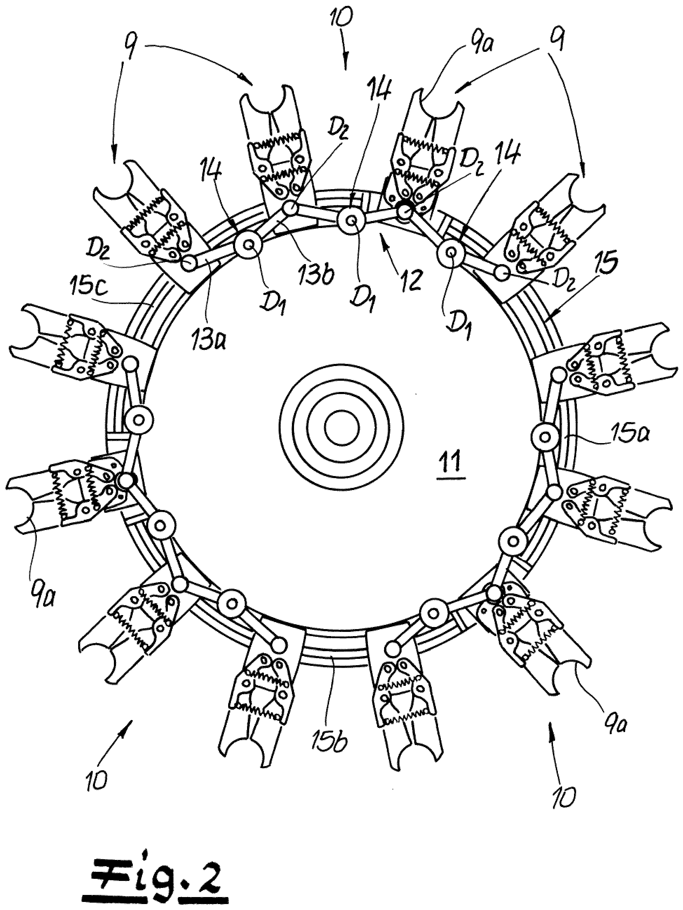

Um eine solche Gruppierung bewirken zu können, sind die als Einlaufrad 7 und Auslaufrad 8 vorgesehenen Behältertransportsterne derart ausgebildet, dass vier in Umfangsrichtung hintereinander angeordnete Behälteraufnahmen 9 zur Bildung einer gemeinsamen Transportgruppe 10 relativ zueinander an einem Träger 11 des Behältertransportsterns in Umfangsrichtung verschiebbar eingerichtet sind. Eine solche Ausgestaltung ist beispielsweise in der Fig. 2 gezeigt.

Gemäß dieser Ausgestaltung sind insgesamt drei Transportgruppen 10 vorgesehen, welche durch Rotation zwischen einer Eingabe- und einer Ausgabeposition bewegbar sind. Die Behälteraufnahmen 9 sind als passive Greifer ausgebildet und können die Behälter 6 unterhalb eines sogenannten Neckringes halten.

Anhand der Fig. 2 ist ferner ersichtlich, dass die Transportgruppen 10 jeweils aus vier Behälteraufnahmen 9 bestehen, so dass sich eine Übereinstimmung mit der Anzahl der Behandlungsmodule 4 einer Behandlungsgruppe 5 in dem Beschichtungsrad 1 ergibt.

Die vier Behälteraufnahmen 9 einer Transportgruppe 10 müssen nunmehr im Zuge der Rotation in eine erste Teilung t₁ zueinander bewegt werden. Hierzu ist eine mechanische Koppelungseinrichtung in Form einer ziehharmonikaartigen Gelenkverbindung 12 vorgesehen, welche die 4 Behälterhalterung 9 einer Transportgruppe 10 miteinander verbindet.

Die Gelenkverbindung 12 verbindet jeweils zwei hintereinander angeordnete Behälteraufnahmen 9 über eine erste und eine zweite Gelenksstange 13a, 13b, welche in einem ersten Drehpunkt D₁ gelenkig miteinander verbunden sind. Darüber hinaus schließen die Gelenkstangen 13a, 13b in einem zweiten Drehpunkt D₂ an die jeweiligen Behälteraufnahmen 9 an, sodass durch Zusammenfahren der Behälteraufnahmen 9 eine ziehharmonikaartige Struktur ausgebildet wird.

Anhand der Fig. 2 wird ferner deutlich, dass jeweils drei erste und zweite Gelenksstangen 13a, 13b erforderlich sind, um die vier Behälteraufnahmen 9 einer Transportgruppe 10 miteinander zu verbinden. Entsprechend bilden sich auch drei erste Drehpunkte D₁ aus, wobei in den ersten Drehpunkten D₁ jeweils eine Steuerrolle 14 angeordnet ist. Über diese Steuerrollen 14 kann die Bewegung zweier hintereinander angeordneter Behälteraufnahmen 9 zueinander gesteuert werden, wobei lediglich drei der vier Behälteraufnahmen 9 in Umfangsrichtung verschieblich angeordnet sind. Eine innenliegende Behälteraufnahme 9a einer jeden Transportgruppe 10 ist fest mit dem Träger 11 verbunden, sodass diese Behälteraufnahme 9a einen Fixpunkt einer jeden Transportgruppe 10 darstellt.

Zum Verschieben der Behälteraufnahmen 9 ist eine Bogenführung 15 vorgesehen, welche aus mehreren Bogenführungsabschnitten 15a, 15b, 15c besteht und entlang derer die Behälteraufnahmen 9 verschoben werden können.

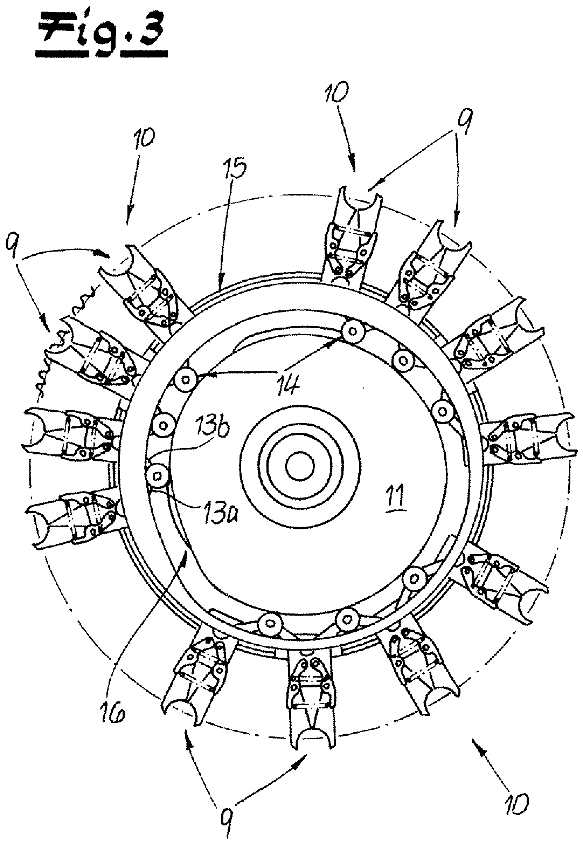

Die Fig. 3 zeigt in diesem Zusammenhang die Anordnung der Behälteraufnahmen 9 während des Betriebes, wobei die Behälter 6 unten liegen rechts in der Eingabeposition eingeführt und oben links in der Ausgabeposition entnommen werden.

Hierbei ist ersichtlich, dass die unten rechts dargestellten Behälteraufnahmen 9 deutlich weiter auseinanderliegen als die Behälteraufnahmen der Transportgruppe 10 oben links. Konstruktiv ergibt sich eine Übereinstimmung mit der Darstellung in der Fig. 2, wobei nunmehr die Steuerrollen 14 entlang einer Steuerkurve 16 entlangrollen, welche eine radiale Verschiebung der Steuerrollen 14 und damit auch ein Verschwenken der ersten und zweiten Gelenksstangen 13a, 13b zueinander bewirken. Dieses Verschwenken hat zur Folge, dass die Behälteraufnahmen 9 entlang der Bogenführung 15 verschoben werden und sodann in der Ausgabeposition eine Anordnung mit einer ersten Teilung t₁ ermöglicht wird.

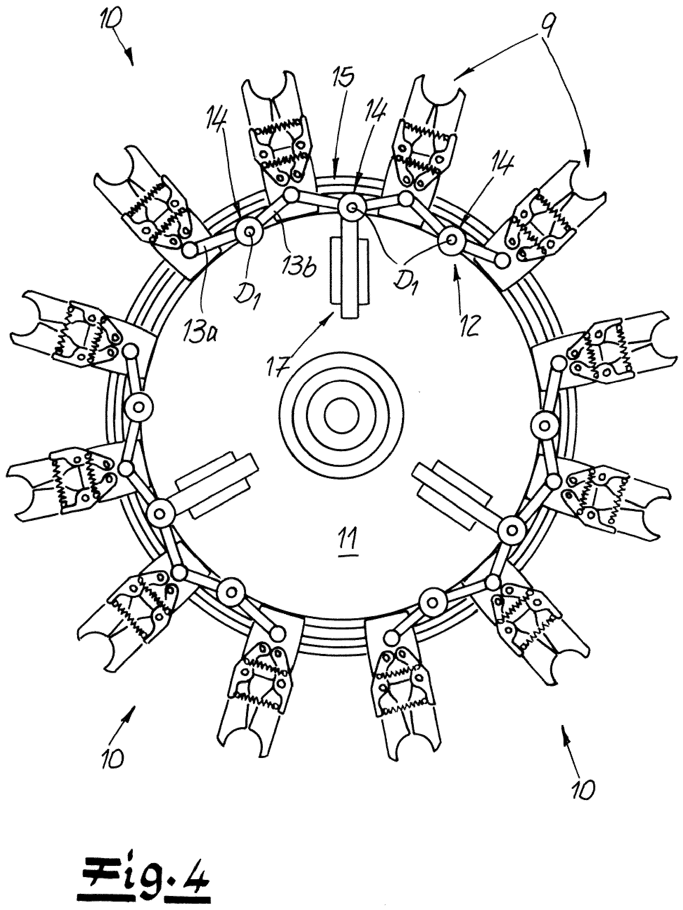

Die Fig. 4 zeigt eine Abwandlung der Ausgestaltung gemäß der Fig. 2, bei der sämtliche Behälteraufnahmen 9 verschiebbar entlang einer umlaufend angeordneten Bogenführung 15 ausgebildet sind.

Den Fixpunkt in Umfangsrichtung bildet nunmehr der mittlere erste Drehpunkt D₁, welcher entlang einer Linearführung 17 ausschließlich radial verschieblich angeordnet ist. Entsprechend werden nunmehr also nicht mehr länger die Behälteraufnahmen 9 gegenüber einer feststehenden Behälterhalterung 9a verfahren. Vielmehr erfolgt eine Verschiebung sämtlicher Behälteraufnahmen 9 gegenüber einem feststehenden mittleren ersten Drehpunkt D₁. Eine solche Ausgestaltung ist insbesondere deshalb sinnvoll, da der mittlere erste Drehpunkt D₁ die Mitte einer jeden Transportgruppe 10 darstellt.

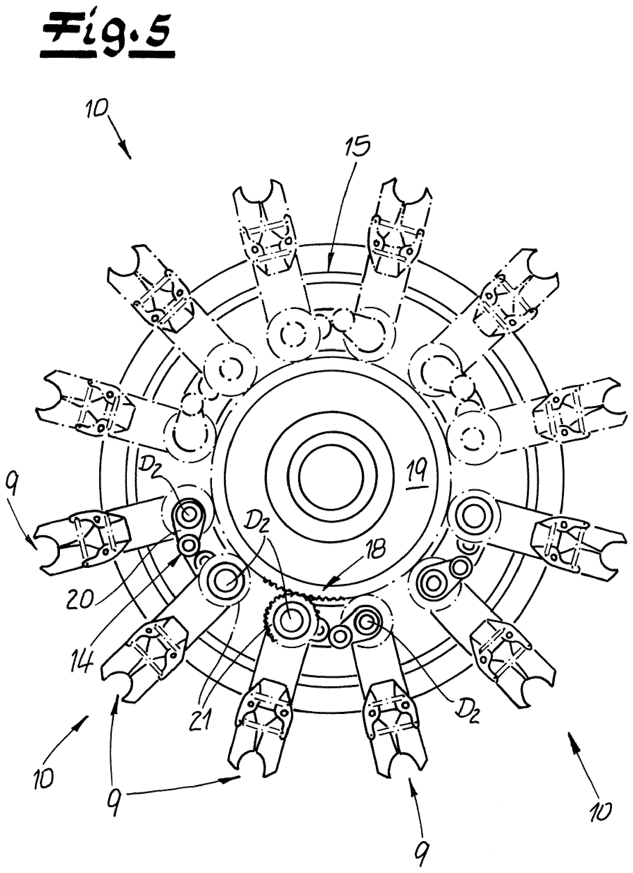

Die Fig. 5 zeigt eine Ausgestaltung, bei der eine mechanische Kopplungseinrichtung in Form eines Zahnradgetriebes 18 vorgesehen ist. Wie auch gemäß der Fig. 2 bilden weiterhin vier Behälteraufnahmen 9 eine Transportgruppe 10, wobei diese im Gegensatz der Fig. 2 nicht mehr unmittelbar miteinander verbunden sind. Vielmehr gibt sich die Zuordnung anhand der Anordnung auf einem Stirnrad 19, welches fest auf dem Träger 11 in einer koaxialen Art und Weise angeordnet und verbunden ist. Die Behälteraufnahmen 9 weisen jeweils in dem zweiten Drehpunkt D₂ ein Planetenrad 21 auf, welches entlang des Stirnrades 19 abrollbar ist. Die Behälteraufnahmen 9 selbst werden weiterhin in der Bogenführung 15 geführt, wobei durch Bewegung der Planetenräder 21 eine Verschiebung in Umfangsrichtung bewirkt werden kann. Hierzu ist in den zweiten Drehpunkt D₂ an den Planetenrädern 21 ein Anlenkhebel 20 vorgesehen, welcher mittels einer Steuerrolle 14 bewegbar ist. Durch Bewegen der Steuerrollen 14 werden die Anlenkhebel 20 verschwenkt und die Planetenräder 21 in Rotation versetzt.

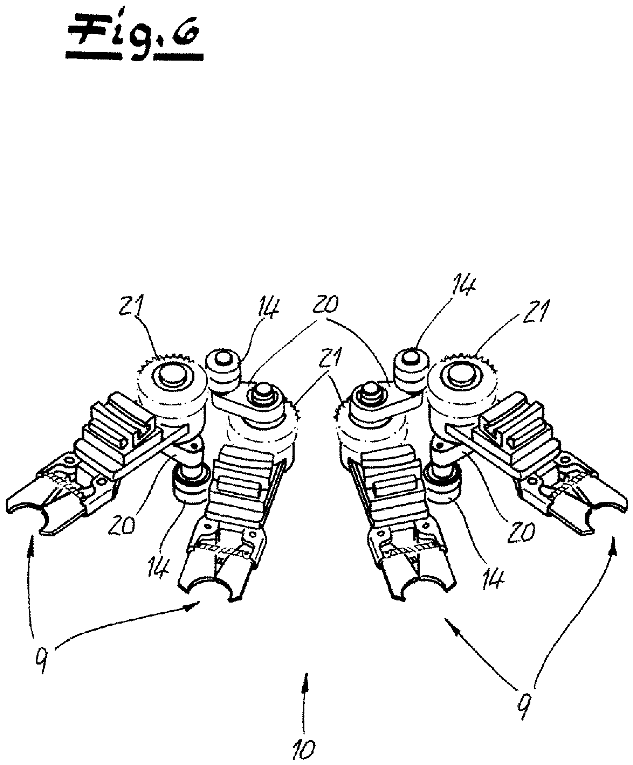

Die Fig. 6 zeigt in einer isometrischen Darstellung die Anordnung der einzelnen Behälteraufnahmen 9 einer Transportgruppe 10. Hierbei fällt auf, dass die äußeren Behälteraufnahmen 9 bezüglich der Transportgruppe 10 einen innenliegenden Anlenkhebel 20 und die innenliegenden Behälterhalterungen 9 einen nach außen gerichteten Anlenkhebel 20 aufweisen. Hierdurch ergibt sich eine symmetrische Darstellungen. Die Symmetrie hat den Vorteil, dass die Anzahl der Steuerkurven halbiert werden kann und vor allem kleine Teilkreisdurchmesser realisierbar sind.

Zugleich sind die Anlenkhebel 20 und auch die Steuerrollen 14 abwechselnd erst auf einer unteren und dann auf einer oberen Seite der Planetenräder 21 angeordnet. Hierdurch ist es möglich, einen möglichst großen Verschwenkwinkel der Anlenkhebel 20 zu bewirken, ohne dass diese sich gegenseitig behindern. Zugleich sind aber auch zwei nicht näher dargestellte Steuerkurven 16 erforderlich, um die einzelnen Behälteraufnahmen 9 einer Transportgruppe 10 verfahren zu können.

### Bezugszeichenliste

- 1: Behandlungsrad
- 2: Einlaufanordnung
- 3: Auslaufanordnung
- 4: Behandlungsmodule
- 5: Behandlungsgruppe
- 6: Behälter
- 7: Einlaufstern
- 8: Auslaufstern
- 9, 9a: Behälteraufnahmen
- 10: Transportgruppe
- 11: Träger
- 12: Gelenkverbindung
- 13a, 13b: Gelenkstangen
- 14: Steuerrolle
- 15a-15c: Bogenführungsabschnitte
- 16: Steuerkurve
- 17: Linearführung
- 18: Zahnradgetriebe
- 19: Stirnrade
- 20: Anlenkhebel
- 21: Planetenrad
- t₁,t₂,t₃: Teilungen
- D_{1,}D_{2,}D₃: Drehpunkte

## Patentansprüche

1. Behältertransportstern, insbesondere für eine Behandlungsanlage, mit einer Vielzahl von an einem Träger (11) angeordneten Behälteraufnahmen (9), welche durch Rotation des Trägers (11) zwischen einer Eingabe- und einer Ausgabeposition bewegbar sind,
**dadurch gekennzeichnet, dass**
zumindest drei in Umfangsrichtung hintereinander angeordnete Behälteraufnahmen (9) zur Bildung einer gemeinsamen Transportgruppe (10) relativ zueinander an dem Träger (9) in Umfangsrichtung verschiebbar ausgebildet sind.

2. Behältertransportstern nach Anspruch 1, **dadurch gekennzeichnet, dass** zumindest zwei Transportgruppen (10) vorgesehen sind, wobei die Transportgruppen (10) bevorzugt durch eine identische Anzahl von Behälteraufnahmen (9) gebildet sind.

3. Behältertransportstern nach einem der vorangegangenen Ansprüche, **dadurch gekennzeichnet, dass** zumindest zwei der Behälteraufnahmen (9) einer Transportgruppe (10) entlang einer an dem Träger (9) gebildeten Bogenführung (15) verschiebbar sind.

4. Behältertransportstern nach Anspruch 3, **dadurch gekennzeichnet, dass** die Bogenführung (15) eine in dem Träger (11) angeordnete Nut ist und wobei zumindest eine bevorzugt zumindest zwei verschiebbar ausgebildete Behälteraufnahmen (9) einer Transportgruppe (10) mit einem Vorsprung in die Nut eingreifen.

5. Behältertransportstern nach einem der vorangegangenen Ansprüche, **dadurch gekennzeichnet, dass** die Behälteraufnahmen (9) zumindest einer Transportgruppe (10) über eine mechanische Koppelungseinrichtung miteinander in Verbindung stehen.

6. Behältertransportstern nach Anspruch 5, **dadurch gekennzeichnet, dass** die mechanische Kopplungseinrichtung als ziehharmonikaartige Gelenkverbindung (12) ausgebildet ist, welche die Behälteraufnahmen (9) einer Transportgruppe (10) miteinander verbindet.

7. Behältertransportstern nach Anspruch 6, **dadurch gekennzeichnet, dass** die Gelenkverbindung (12) über eine erste und eine zweite Gelenkstange (13a, 13b) jeweils zwei hintereinander angeordnete Behälteraufnahmen (9) miteinander verbindet, wobei die Gelenkstangen (13a, 13b) in einem ersten Drehpunkt (D₁) gelenkig aneinander und in einem zweiten Drehpunkt (D₂) an den Behälteraufnahmen (9) befestigt sind.

8. Behältertransportstern nach Anspruch 7, **dadurch gekennzeichnet, dass** jeweils eine der Behälteraufnahmen (9a) einer Transportgruppe (10) feststehend am Träger (11) befestigt oder die Gelenkverbindung (12) ausschließlich radial verschiebblich in einem der ersten Drehpunkte (D₁) ausgebildet ist.

9. Behältertransportstern nach Anspruch 7 oder 8, **dadurch gekennzeichnet, dass** Steuerrollen (14) in den ersten Drehpunkten (D₁) angeordnet sind.

10. Behältertransportstern nach Anspruch 5, **dadurch gekennzeichnet, dass** die mechanische Kopplungseinrichtung als Zahnradgetriebe (18) ausgebildet ist.

11. Behältertransportstern nach Anspruch 10, **dadurch gekennzeichnet, dass** das Zahnradgetriebe (18) aus einem koaxial mit dem Träger (11) verbundenen Stirnrad (19) sowie einer Vielzahl von umlaufend an dem Stirnrad (19) angeordneten Planetenrädern (21) gebildet ist, wobei die Planetenräder (21) jeweils an den Behälteraufnahmen (9) zumindest einer Transportgruppe (10) drehbar in einem zweiten Drehpunkt (D₂) befestigt sind.

12. Behältertransportstern nach Anspruch 11, **dadurch gekennzeichnet, dass** jeweils ein Anlenkhebel (20) in dem zweiten Drehpunkt (D₂) mit den Planetenrädern (21) verbunden ist.

13. Behältertransportstern nach Anspruch 12, **dadurch gekennzeichnet, dass** jeweils eine Steuerrolle (14) an den Anlenkhebel (20) in einem Abstand zum zweiten Drehpunkt (D₂) angeordnet ist.

14. Behältertransportstern nach Anspruch 12 oder 13, **dadurch gekennzeichnet, dass** die Anlenkhebel (20) zweier hintereinander angeordneter Behälteraufnahmen (9) einer Transportgruppe (10), in umlaufender Bewegungsrichtung der Behälteraufnahmen gesehen, auf unterschiedlichen Seiten der Planetenräder (21) angeordnet sind.

15. Behältertransportstern nach einem der Ansprüche 9 bis 14, **dadurch gekennzeichnet, dass** zumindest eine Steuerkurve (16) vorgesehen ist, mit welchen die Steuerrollen (14) in Eingriff stehen.

16. Behältertransportstern nach einem der vorangegangenen Ansprüche, **dadurch gekennzeichnet, dass** die Behälteraufnahmen (9) als Behältergreifer, insbesondere als Neckringgreifer, ausgebildet sind.

17. Behandlungsanlage zum Behandeln von Behältern (6), insbesondere zum Beschichten von Behältern (6), mit einem Behandlungsrad (1) und einer Vielzahl von in Umfangsrichtung hintereinander an dem Behandlungsrad (1) angeordneten Behandlungsmodulen (4), welche jeweils eine Behälterhalterung und eine der Behälterhalterung zugeordnete Behandlungseinheit aufweisen, welche dazu eingerichtet sind, die Behälter (6) während einer Rotation des Behandlungsrades (1) zu behandeln und wobei jeweils zumindest drei hintereinander angeordnete Behandlungsmodule (4) zu einer Behandlungsgruppe (5) zusammengefasst sind und wobei die Behandlungsmodule (4) innerhalb einer Behandlungsgruppe (5) in einer ersten Teilung (t₁) und zwei unmittelbar aneinander angrenzende Behandlungsmodule (4) unterschiedlicher Behandlungsgruppen (5) in einer zweiten Teilung (t₂) zueinander angeordnet sind, wobei die zweite Teilung (t₂) größer ausgebildet ist als die erste Teilung (t1),
**dadurch gekennzeichnet, dass**
zumindest ein Behältertransportstern nach einem der vorangegangenen Ansprüche als Einlaufstern (7) dazu eingerichtet ist, Behälter (6) einer Transportgruppe (10) zwischen der Eingabe- und einer Ausgabeposition mit einer ersten Teilung (t₁) zu gruppieren und an einem Einlauf des Behandlungsrades (1) an eine Behandlungsgruppe (5) zu übergeben.

18. Behandlungsanlage nach Anspruch 17, **dadurch gekennzeichnet, dass** zumindest ein weiterer Behältertransportstern nach einem der vorangegangenen Ansprüche als Auslaufstern (8) dazu eingerichtet ist, Behälter (6) einer Behandlungsgruppe (5) aus dem Behandlungsrad (1) zu entnehmen und innerhalb einer Transportgruppe (5) zwischen der Eingabe- und einer Ausgabeposition, ausgehend von der ersten Teilung (t₁), zu degruppieren.

19. Behandlungsanlage nach Anspruch 17 oder 18, **dadurch gekennzeichnet, dass** die Behandlungseinheiten als Beschichtungseinheiten ausgebildet sind.
